(19) Europäisches Patentamt
European Patent Office
Office européen des brevets

(11) Veröffentlichungsnummer: **0 141 400 B1**

(12) **EUROPÄISCHE PATENTSCHRIFT**

(45) Veröffentlichungstag der Patentschrift: **08.08.90**

(51) Int. Cl.$^5$: **G 03 F 7/022**

(21) Anmeldenummer: **84113094.1**

(22) Anmeldetag: **30.10.84**

# (54) Lichtempfindliches Gemisch und Verfahren zur Herstellung von negativen Reliefkopien.

(30) Priorität: **08.11.83 IT 2363483**

(43) Veröffentlichungstag der Anmeldung:
**15.05.85 Patentblatt 85/20**

(45) Bekanntmachung des Hinweises auf die Patenterteilung:
**08.08.90 Patentblatt 90/32**

(84) Benannte Vertragsstaaten:
**DE FR GB IT NL SE**

(56) Entgegenhaltungen:
**FR-A-2 090 380**
**GB-A-2 082 339**

**IEE PROCEEDINGS, Sections A a I, Band 130, Nr. 5, Teil 1, Oktober 1983, Seiten 245-251, Old Woking, Surrey, GB; A.LEDWITH: "Chemistry of polymeric resists useful in microlithography"**

(73) Patentinhaber: **HOECHST AKTIENGESELLSCHAFT**
**Postfach 80 03 20**
**D-6230 Frankfurt am Main 80 (DE)**
(73) Patentinhaber: **I.M.G. INDUSTRIA MATERIALI GRAFICI S.p.A.**
**S.S. del Brennero Km. 305.800**
**I-37020 Volargne di Dolcé (IT)**

(72) Erfinder: **Guzzi, Alberto, Dr.**
**Via A. Doria, 24**
**I-37138 Verona (IT)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 141 400 B1

**Beschreibung**

Die vorliegende Erfindung betrifft ein lichtempfindliches Gemisch, das insbesondere zur Herstellung von Druckplatten bestimmt ist und das wahlweise eine positive oder negative Kopie einer Vorlage zu liefern vermag, d.h. daß man sowohl von einer positiven als auch von einer negativen Vorlage eine positive Kopie herstellen kann.

In der Reproduktionstechnik ist die Verwendung von mit lichtempfindlichen Schichten überzogenen Trägern der verschiedensten Arten und aus verschiedenen Werkstoffen seit langem weit verbreitet; sie umspannt ein sehr umfangreiches Gebiet vom Offsetdruck bis hin zur Herstellung von gedruckten Schaltungen. Die lichtempfindlichen Schichten werden gewöhnlich in zwei Gruppen eingeteilt, d.h. negativ arbeitende Schichten, mit denen ein Positiv von einer negativen Vorlage gewonnen werden kann, und positiv arbeitende Schichten, mit denen ein Positiv von einer positiven Vorlage gewonnen werden kann.

Die negativ arbeitenden Schichten sind so beschaffen, daß die nicht mit aktinischem Licht belichteten und daher unverändert gebliebenen Stellen von einem Entwickler aufgelöst werden; dadurch entsteht ein negatives Bild. Die positiv arbeitenden Schichten sind dagegen so beschaffen, daß nur die mit aktinischem Licht belichteten Stellen in einem alkalischen Entwickler löslich werden, wodurch ein positives Bild entsteht.

Für die positiv arbeitenden lichtempfindlichen Schichten werden heute allgemein o-Naphthochinondiazide verwendet, z.B. die in den DE-C 854 890, 865 109, 879 203, 894 959, 938 233, 11 24 817, 11 09 521, 11 20 273, 11 18 606, 11 14 705 oder im US-A 3 635 709 beschriebenen Materialien.

Diese o-Naphthochinondiazide ermöglichen es, positiv arbeitende lichtempfindliche Schichten herzustellen, die sehr dauerhaft sind und leicht mit wäßrig-alkalischen Lösungen entwickelt werden können, ohne daß man auf Entwickler auf der Basis von organischen Lösemitteln angewiesen ist.

Die FR-A-20 90 380 beschreibt ein negativ arbeitendes, lichtempfindliches Material aus einem Träger, einer hydrophilen Schicht, einer lichtempfindlichen, z.B. Diazoniumsalz enthaltenden Schicht und einer im wesentlichen Wasser undurchläßigen, bessere Farbannahme bewirkenden Schicht, in der quaternäre Ammoniumverbindungen mit zwei Alkylgruppen mit mehr als sieben Kohlenstoffatomen vorhanden sind.

Es sind ferner lichtempfindliche Schichten auf der Basis von o-Chinondiaziden bekannt, die, wenn sie nach dem Belichten eine gewisse Zeit erwärmt werden, eine Bildumkehr erfahren, so daß ein positives Bild von einer negativen Vorlage und umgekehrt erhalten wird.

Die DE-A 25 29 054 beschreibt lichtempfindliche Schichten dieser Art; dabei ist die Anwesenheit von 1-Hydroxyethyl-2-alkylimidazolin erforderlich, und die Platte muß mindestens 10 Minuten lang auf 105°C erhitzt werden. Auch in der DE-A 28 55 723 sind lichtempfindliche Schichten der genannten Art beschrieben; der Umkehrprozeß wird durch Stoffe des Typs

$$R-\underset{\displaystyle O}{C}-NH-CH_2-CH_2-NH-CH_2-CH_2-OH$$

bewirkt; auch in diesem Fall muß die Platte mindestens 10 Minuten auf Temperaturen über 100°C erwärmt werden.

Die EP-A 0 024 916 beschreibt ein Gemisch, das neben der lichtempfindlichen Verbindung ein Harz aus der Gruppe der Novolake enthält. Dieses Gemisch, mit dem von einer Positivvorlage sowohl Positive als auch Negative erhalten werden können, muß für den Umkehrprozeß 30 Minuten auf 95°C oder 5 Minuten auf 150°C erwärmt werden.

Die GB-A 2 082 339 beschreibt eine lichtempfindliche Schicht für lithographische Platten auf der Basis von o-Chinondiaziden und Resolharzen, die von positiven wie auch negativen Vorlagen ausgehend positive Bilder liefern kann. Für den Umkehrprozeß muß diese Schicht auf mindestens 120°C erhitzt werden, wenn die Behandlung nicht länger als 2 Minuten dauern soll.

In der US-A 4 196 003 wird die Verwendung von o-Naphthochinondiaziden für die Herstellung von vorsensibilisierten Druckplatten beschrieben, die je nach der Behandlung, der die lichtempfindliche Schicht unterzogen wird, positive oder negative Bilder ergeben können. Wird die Platte nach der Belichtung durch eine positive Vorlage auf die übliche Art und Weise mit einer alkalischen Lösung entwickelt, so daß die belichteten Stellen durch Auflösung beseitigt werden, erhält man ein positives Bild.

Wird die Platte dagegen durch eine negative Vorlage belichtet, so wird sie danach etwa 10 Minuten lang auf ca. 100°C erwärmt, dann nochmals mit der gleichen Lichtquelle wie zuvor ohne Vorlage belichtet und im gleichen alkalischen Entwickler wie oben erwähnt entwickelt, wobei ein positives Bild entsteht. Beim letztgenannten Verfahren kommt es an den bildmäßig belichteten Stellen der Schicht zu einer durch die Wärme bewirkten Vernetzungsreaktion, die zur Unlöslichkeit der Schicht im alkalischen Entwickler führt, während die übrigen Stellen durch die zweite Belichtung löslich werden.

Die lichtempfindliche Schicht, mit der dieses Umkehrverfahren durchgeführt wird, enthält mindestens ein o-Naphthochinondiazid, ein Phenol- oder Kresolformaldehydharz und mindestens ein sekundäres oder tertiäres Amin. Dieses Amin wirkt als Katalysator bei der thermischen Vernetzung.

Die Toxizität der Amine ist bekannt. Die Gegenwart eines Amins in der lichtempfindlichen Schicht stellt eine Gefahr für die Gesundheit der damit arbeitenden Personen sowie eine potentielle Verunreinigungsquelle dar, weil die Schicht beim Beschichten und während der Behandlung auf solche

Temperaturen erwärmt wird, daß Teile des Amins zum Verdampfen in die umgebende Luft neigen. Beim Entwickeln wird ferner ein Teil der Schicht und damit das darin enthaltene Amin herausgelöst, was besondere Maßnahmen zur Entgiftung des erschöpften Entwicklers erfordert.

Als Nachteile des Standes der Technik sind somit die Toxizität der Schichtzusätze und die Dauer der Wärmebehandlung anzusehen. Von den Verbrauchern werden kurze Behandlungszeiten gewünscht.

Erfindungsgemäß wurde überraschend gefunden, da lichtempfindliche Schichten, mit denen die positive wie auch negative Reproduktion eines Bildes möglich ist, ohne Verwendung von Aminen und mit bis um 80% verkürzter Wärmebehandlung bei bis zu 20% niedrigeren Temperaturen hergestellt werden können.

Aufgabe der Erfindung war es, ein lichtempfindliches Gemisch auf der Basis von von 1,2-Chinondiaziden und ein Verfahren vorzuschlagen, mit denen es möglich ist, eine Bildumkehr zu erzeugen. Dabei sollten im Vergleich zu bekannten Materialien und Verfahren die Verarbeitungszeiten verkürzt bzw. die Verarbeitungstemperaturen herabgesetzt und die Gefahr des Entstehens gesundheitsschädlicher Gase oder Dämpfe vermieden werden.

Erfindungsgemäß wird ein lichtempfindliches Gemisch vorgeschlagen, das als lichtempfindliche Verbindung ein 1,2-Chinondiazid enthält und das dadurch gekennzeichnet ist, daß es ferner eine quaternäre Ammoniumverbindung enthält.

Erfindungsgemäß wird ferner ein Verfahren zur Herstellung von negativen Reliefkopien vorgeschlagen, bei dem ein lichtempfindliches Material, das als lichtempfindliche Verbindung ein 1,2-Chinondiazid enthält, bildmäßig belichtet, danach erwärmt, nach dem Abkühlen nochmals ohne Vorlage belichtet und dann mittels eines wäßrig-alkalischen Entwicklers entwickelt wird.

Das erfindungsgemäße Verfahren ist dadurch gekennzeichnet, daß die lichtempfindliche Schicht ein Gemisch gemäß Anspruch 1 enthält.

Lichtempfindliche 1,2-Chinondiazide sind z.B. in dem Buch von J. Kosar "Light-Sensitive Systems", John Wiley & Sons, Inc., New York, sowie in allen zuvor erwähnten Druckschriften beschrieben.

Die genannte quaternäre Ammoniumverbindung, die als Vernetzungskatalysator wirkt, ist vorteilhaft ein Hydroxid oder ein Salz einer Tetraalkylammonium- oder Trialkylarylammoniumverbindung oder ein N-Alkylpyridiniumderivat. Beispiele für solche Verbindungen sind die Halogenide, p-Toluolsulfonate, Tetrabutylammonium-, Trimethylphenylammonium-, Benzyltrimethylammonium- und Kokosfettalkyldimethylbenzylammoniumhydroxide (hierbei ist der Kokosfettalkylrest eine Mischung von Alkylresten mit 10 bis 18 Kohlenstoffatomen, wobei Reste mit 12 Kohlenstoffatomen vorwiegen).

Die quaternären Ammoniumverbindungen in Form von Hydroxiden sind außer in wäßrigen oder alkoholischen Lösungen kaum existent; diese können aus den entsprechenden Salzen gewonnen werden, indem man diese vor oder nach dem Zusatz zu der Beschichtungslösung wie in den nachstehenden Beispielen beschrieben mit einem Anionenaustauschharz behandelt. Das Verhältnis von o-Chinondiazid zu quaternärer Ammoniumverbindung kann zwischen 0,03 und 0,5 Gewichtsteilen quaternärer Ammoniumverbindung je 1 Gewichtsteil o-Chinondiazid liegen. Die lichtempfindliche Schicht nach der vorliegenden Erfindung kann neben den obengenannten Bestandteilen andere Komponenten enthalten, z.B. Farbstoffe, Indikatoren oder Pigmente, um das Bild gut sichtbar zu machen, verschiedene Harzarten, um die Entwicklungsfähigkeit der Schicht zu verbessern oder ihre mechanische Festigkeit zu erhöhen, Tenside, Farbumschlaggemische oder andere Additive, die an sich bekannt sind. Von besonderem Vorteil ist in bekannter Weise der Zusatz von wasserunlöslichen, in wäßrig-alkalischen Lösungen löslichen polymeren Bindemitteln. Für diesen Zweck haben sich insbesondere Phenolharz-Novolake bewährt.

Das lichtempfindliche Gemisch wird zur Herstellung von lichtempfindlichem Material gleichmäßig auf einen Träger, wie eine Metallplatte, z.B. aus Aluminium, verchromtem Stahl, verkupfertem und verchromtem Stahl oder verchromtem Messing, aufgebracht. Das Gewicht der trokkenen Schicht kann zwischen 0,1 und 5 $g/m^2$ liegen.

Dieses Material wird wie üblich durch eine Filmvorlage mit aktinischem Licht belichtet. Als Lichtquelle kommt z.B. eine Xenon-, eine Metallhalogenid- oder eine Bogenlampe infrage. Zur Herstellung einer positiven Druckplatte folgt danach die Entwicklung in einer wäßrigalkalischen Lösung, z.B. einer 5%igen Natriumsilikatlösung in Wasser. Um eine negative Druckplatte zu erhalten, muß nach der Belichtung eine Wärmebehandlung vorgenommen werden, gefolgt von einer zweiten Belichtung der ganzen Plattenoberfläche, zweckmäßig mit dem gleichen aktinischen Licht, die so lange dauern muß, bis die bei der bildmäßigen Belichtung nicht von Licht getroffenen Stellen der Schicht beim Entwickeln löslich werden. Danach wird die Platte im gleichen alkalischen Entwickler wie oben entwickelt.

Das erfindungsgemäße lichtempfindliche Gemisch vermeidet die Toxizitätsprobleme, da anstelle der Amine die bekannten quaternären Ammoniumverbindungen zum Einsatz kommen, die als Desinfektionsmittel für den inneren und äußeren Gebrauch sowie als kationische Tenside Anwendung finden und nicht toxisch sind, sondern verbreitet in der Pharmazie, in der Industrie und als Detergentien verwendet werden. Das Gemisch ermöglicht ferner eine Wärmebehandlung bei tieferen Temperaturen und in kürzerer Zeit als es bei bekannten Gemischen gleicher Art möglich war. Das Gemisch wird nach der Bildbelichtung im allgemeinen auf 80 bis 120, vorzugsweise 95 bis 105°C erwärmt. Die Dauer des Erwärmens beträgt gewöhnlich 0,5 bis 5, bevorzugt 1 bis 4 Minuten. Für einen Vergleich zwischen den erfindungsgemäßen Gemischen und den bekannten aminhaltigen Gemischen wurden verschiedene Offsetplatten vorbereitet, die mit Ausnahme des Zusatzmittels die gleichen Bestandteile enthielten. Als

Zusätze wurden die in der US-A 4 196 003 beschriebenen Amine Triethanolamin, Diethylanilin und Hexamethylentetramin sowie die quaternären Ammoniumverbindungen Tetrabutylammoniumhydroxid, Kokosfettalkyldimethylbenzylammoniumhydroxid und Benzyltrimethylammoniumbromid verwendet und miteinander verglichen.

Die folgenden Beispiele beschreiben bevorzugte Ausführungsformen der Erfindung. Mengenverhältnisse und Prozentzahlen sind, wenn nichts anderes angegeben ist, in Gewichtseinheiten zu verstehen. Gewichtsteile (Gt) und Volumenteile (Vt) stehen zueinander im Verhältnis von g zu $cm^3$.

Beispiel 1

Es wurden 6 Beschichtungslösungen hergestellt.

Lösung A

1,5 Gt des Reaktionsprodukts aus 1,2-Naphthochinon-2-diazid-4-sulfonylchlorid und einem Kresol-Formaldehyd-Novolak mit einem Erweichungsbereich von 105 bis 120°C (nach Kapillarmethode DIN 53 181), 1,5 Gt des gleichen, jedoch nicht veresterten Novolaks und 0,3 Gt Triethanolamin wurden in 30 Gt 2-Ethoxy-ethanol gelöst.

Lösung B

Gleiche Zusammensetzung wie Lösung A, aber anstelle von 0,3 Gt Triethanolamin wurden 0,3 Gt Diethylanilin verwendet.

Lösung C

Gleiche Zusammensetzung wie Lösung A, aber anstelle von 0,3 Gt Triethanolamin wurden 0,25 Gt Hexamethylentetramin verwendet.

Lösung D

Gleiche Zusammensetzung wie Lösung A, aber anstelle von 0,3 Gt Triethanolamin wurden 2 Gt ca. 10%ige Tetrabutylammoniumhydroxidlösung verwendet, die wie im nachfolgenden Beispiel 3 beschrieben hergestellt worden war.

Lösung E

Gleiche Zusammensetzung wie Lösung A, aber anstelle von 0,3 Gt Triethanolamin wurden 2 Gt ca. 10%ige Kokosfettalkyldimethylbenzylammoniumhydroxidlösung verwendet.

Lösung F

Gleiche Zusammensetzung wie Lösung A, aber anstelle von 0,3 Gt Triethanolamin wurden 0,2 Gt Benzyltrimethylammoniumbromid verwendet.

Mit jeder Lösung wurde ein Schichtträger aus verchromtem Stahl beschichtet. Nach Entfernung des Lösemittels wurden die sechs so erhaltenen Platten durch die gleiche negative Vorlage hindurch belichtet, danach 2 Minuten lang einer Temperatur von 100°C ± 5°C ausgesetzt, ein zweites Mal ohne Vorlage belichtet und dann 1 Minute in einer 3%igen Natriumsilikatlösung entwickelt, wie es im Beispiel 1 der US-A 4 196 003 angegeben ist. Nach dieser Behandlung ergaben nur die aus den Lösungen D, E und F hergestellten Schichten ein positives Bild, wogegen die aus den Lösungen A, B und C erhaltenen Schichten von der Entwicklungsflüssigkeit vollständig aufgelöst und entfernt wurden, so daß der bloße Träger zurückblieb.

Es wurde festgestellt, daß die Verweilzeit bei 100°C ± 5°C auf mindestens 10 Minuten verlängert werden muß, um mit den drei letztgenannten Schichten ein annehmbares positives Bild zu gewinnen. Das ist übrigens auch in den Beispielen der US-A 4 196 003 vorgesehen.

Wenn zum Entwickeln, wie in den Beispielen 5 und 6 der US-A 4 196 003 angegeben, eine 5%ige Natriumsilikatlösung in Wasser verwendet wurde, waren die Ergebnisse noch unterschiedlicher zugunsten der Lösungen D, E und F.

Die 5%ige Natriumsilikatlösung ist übrigens den gewöhnlich für vorsensibilisierte positiv arbeitende Offsetplatten verwendeten Entwicklern ähnlicher als die 3%ige Natriumsilikatlösung. Dank der Möglichkeit, die Behandlungsdauer wesentlich zu verkürzen, ohne die Behandlungstemperatur erhöhen zu müssen, erweisen sich die erfindungsgemäß eingesetzten quaternäre Ammoniumverbindungen enthaltenden Zusammensetzungen bei der Anwendung als besonders vorteilhaft.

Beispiel 2

1,5 Gt des in Beispiel 1 verwendeten Umsetzungsprodukts von 1,2-Naphthochinon-2-diazid-4-sulfonylchlorid und Novolak, 1,5 Gt Novolak wie in Beispiel 1 und 0,1 Gt Tetrabutylammoniumbromid wurden in 60 Gt 2-Ethoxy-ethanol gelöst. Dann wurde die Lösung ca. 15 Minuten unter mäßigem Rühren mit 6 Gt eines schwachen Anionenaustauschharzes behandelt, das anschließend abfiltriert wurde. In der filtrierten Lösung wurden 0,02 Gt Bromphenolblau gelöst. Die so gewonnene Lösung wurde auf eine

elektrolytisch aufgerauhte Aluminiumplatte aufgebracht. Nach Verdampfen des Lösemittels erhielt man eine lichtempfindliche Platte, die mit einer trockenen Schicht mit einem Flächengewicht von ca. 2 $g/m^2$ überzogen war.

a) Herstellung des Umkehrbildes

Die Platte wurde in üblicher Weise 90 Sekunden durch eine negative Filmvorlage hindurch belichtet, wobei als Lichtquelle eine im Abstand von 100 cm aufgestellte 5 kW Metallhalogenidlampe verwendet wurde. Nach der Belichtung wurde die Platte zwei Minuten auf 100°C erwärmt und dann ohne Vorlage 90 Sekunden unter der gleichen Lichtquelle belichtet. Durch anschließendes Entwickeln der Platte innerhalb von 30 Sekunden mit 5%iger Natriumsilikatlösung entstand ein positives Bild. Die Platte konnte erfolgreich als Offsetplatte verwendet werden.

b) Herstellung eines positiven Bildes

Um von einer positiven Vorlage ein positives Bild zu gewinnen, wurden die oben beschriebenen Vorgänge wiederholt mit dem Unterschied, daß die Platte nach der ersten Belichtung ohne Wärmebehandlung und weitere Belichtung entwickelt wurde. Dabei erhielt man ein positives Bild, denn die belichteten Stellen der Schicht wurden vom Entwickler gelöst. Die Platte konnte erfolgreich als Offsetdruckplatte verwendet werden.

Beispiel 3

1,5 Gt des aus 1,2-Naphthochinon-2-diazid-4-sulfonylchlorid und Novolak wie in Beispiel 1 gewonnenen Reaktionsprodukts und 1,5 Gt Novolak wurden in 58 Gt 2-Ethoxy-ethanol gelöst. Der Lösung wurden 2 Vt einer wie nachstehend beschrieben zubereiteten ca. 10%igen Tetrabutylammoniumhydroxidlösung zugesetzt. Die so erhaltene lichtempfindliche Lösung wurde mit einer Schleuder auf eine Platte aus verchromtem Stahl aufgetragen. Nach Verdampfen des Lösemittels erhielt man eine lichtempfindliche Platte, die mit einer trockenen Schicht mit einem Flächengewicht von ca. 2 $g/m^2$ überzogen war.

a) Herstellung des Umkehrbildes

Wie in Beispiel 2a beschrieben, wurde mit der negativen Vorlage ein positives Bild erhalten. Die platte wurde mit Erfolg als Offsetdruckplatte verwendet.

b) Herstellung eines positiven Bildes

Wie in Beispiel 2b beschrieben, wurde mit der positiven Vorlage ein positives Bild erhalten. Die Platte wurde mit Erfolg als Offsetdruckplatte verwendet.

c) Zubereitung der Tetrabutylammoniumhydroxidlösung in 2-Ethoxy-ethanol

5 Gt Tetrabutylammoniumbromid wurden bei Raumtemperatur in 45 Gt 2-Ethoxy-ethanol gelöst. Zu der Lösung wurden 5 Gt eines schwachen Anionenaustauschharzes gegeben. Nach 15 Minuten mäßigem Rühren wurde der Ionenaustauscher abfiltriert.

Beispiel 4

Es wurde in gleicher Weise gearbeitet wie in Beispiel 2 beschrieben, aber unter Verwendung von 1,5 Gt des Reaktionsprodukts aus 1,2-Naphthochinon-2-diazid-5-sulfonylchlorid und Novolak anstelle des dort angegebenen Reaktionsprodukts. Dabei wurden im wesentlichen die gleichen Ergebnisse wie im Beispiel 2 erzielt.

Beispiel 5

2,6 Gt Novolak, 0,4 Gt 2,3,4-Trihydroxy-benzophenon-bis (1,2-naphthochinon-2-diazid-5-sulfonsäureester) und 1 Vt der in Beispiel 3c beschriebenen Tetrabutylammoniumhydroxidlösung wurden in 30 Gt 2-Ethoxy-ethanol gelöst. Die so gewonnene lichtempfindliche Lösung wurde zur Beschichtung einer Trimetallplatte verwendet, die aus einer Stahlplatte bestand, die mit einer ca. 5 µm dicken Kupferschicht und darüber mit einer ca. 1,5 µm dicken kristallinen Chromschicht überzogen war. Die lichtempfindliche Schicht auf der Platte hatte ein Gewicht von ca. 3,5 $g/m^2$.

Durch Behandeln der Platte nach einem der beiden in den vorhergehenden Beispielen beschriebenen Verfahren erhielt man ein positives Bild von einer negativen Vorlage bzw. ein positives Bild von einer positiven Vorlage. Die durch die Entwicklung freigelegte Chromschicht wurde geätzt. Dazu wurde eine Lösung von 70 Gt wasserfreiem Zinkchlorid und 5 Gt konzentrierter Salzsäure in 25 Gt Wasser verwendet. Dies führte zur Auflösung der Chromschicht und damit zur Freilegung der Kupferoberfläche entsprechend dem aus der darüberliegenden organischen Schicht bestehenden Bild. Nach dem Ätzen wurde die organische Schicht mit 2-Ethoxy-ethanol vollkommen abgelöst. Dadurch entstand auf der Platte ein aus den beiden Metallen Kupfer und Chrom bestehendes Bild. Als Offsetdruckplatte für hohe Auflagen wurden mit dieser Platte sehr gute Ergebnisse erzielt.

Beispiel 6

2,6 Gt Novolak, 0,4 Gt p-tert.-Butylphenol-1,2-naphthochinon-2-diazid-5-sulfonsäureester und 0,2 Gt Trimethylbenzylammoniumbromid wurden in 60 Gt 2-Methoxy-ethanol gelöst, und diese Lösung wurde zur Beschichtung einer elektrochemisch aufgerauhten und anodisch oxidierten Aluminiumplatte verwendet. So erhielt man eine lichtempfindliche platte, die durch Behandlung nach den in den vorhergehenden Beispielen beschriebenen wahlweisen Verfahren je nach Behandlung negative oder positive Offsetdruckplatten mit guten Druckeigenschaften und Auflagen ergab.

Beispiel 7

Durch gleiches Vorgehen wie in Beispiel 2 beschrieben, aber unter Verwendung von 0,1 Gt Hexadecylpyridiniumchlorid anstelle von 0,1 Gt Tetrabutylammoniumbromid, wurden ähnliche Ergebnisse wie in Beispiel 2 erzielt.

Beispiel 8

Durch gleiches Vorgehen wie in Beispiel 6, wobei aber das Trimethylbenzylammoniumbromid durch die gleiche Menge 50%iger Kokosfettalkyldimethylbenzylammoniumchloridlösung ersetzt wurde, erreichte man praktisch die gleichen Ergebnisse wie im Beispiel 6.

Beispiel 9

Es wurde wie in Beispiel 8 vorgegangen, aber anstelle von 0,2 Gt 50%iger wäßriger Kokosfettalkyldimethylbenzylammoniumchloridlösung wurden 2 Vt einer Kokosfettalkyldimethylbenzylammoniumhydroxidlösung verwendet, die durch Auflösung von 5 Gt 50%iger wäßriger Kokosfettalkyldimethylbenzylammoniumchloridlösung in 45 Gt 2-Methoxy-ethanol erhalten wurde, wobei der Lösung 5 Gt eines schwachen Anionenaustauschharzes zugefügt wurden und das Harz nach 15 Minuten mäßigem Rühren abfiltriert wurde. Dabei wurden im wesentlichen die gleichen Ergebnisse wie in Beispiel 6 erzielt.

Beispiel 10

3 Gt des Reaktionsprodukts aus 1,2-Naphthochinon-2-diazid-5-sulfonylchlorid und Novolak und 2 Gt Kokosfettalkyldimethylbenzylammoniumhydroxidlösung, deren Zubereitung in Beispiel 9 beschrieben ist, wurden in 58 Gt 2-Methoxy-ethanol gelöst. Nach dem im Beispiel 2 beschriebenen Verfahren erhielt man mit dieser Lösung Offsetdruckplatten von guter Qualität, die je nach Behandlung ein Positiv oder ein Negativ ergaben.

**Patentansprüche**

1. Lichtempfindliches Gemisch, das als lichtempfindliche Verbindung ein 1,2-Chinondiazid enthält, dadurch gekennzeichnet, daß es ferner eine quaternäre Ammoniumverbindung enthält.

2. Lichtempfindliches Gemisch nach Anspruch 1, dadurch gekennzeichnet, daß es 0,03 bis 0,5 Gew.-Teile der quaternären Ammoniumverbindung zu je 1 Gew.-Teil 1,2-Chinondiazid enthält.

3. Lichtempfindliches Gemisch nach Anspruch 1, dadurch gekennzeichnet, daß die quaternäre Ammoniumverbindung eine Tetraalkylammonium-, Trialkylarylammonium- oder N-Alkylpyridiniumverbindung ist.

4. Lichtempfindliches Gemisch nach Anspruch 1, dadurch gekennzeichnet, daß die quaternäre Ammoniumverbindung ein Hydroxid, Halogenid oder p-Toluolsulfonat ist.

5. Lichtempfindliches Gemisch nach Anspruch 1, dadurch gekennzeichnet, daß es ferner ein wasserunlösliches, in wäßrig-alkalischen Lösungen lösliches polymeres Bindemittel enthält.

6. Lichtempfindliches Gemisch nach Anspruch 5, dadurch gekennzeichnet, daß das polymere Bindemittel ein Novolak ist.

7. Verfahren zur Herstellung von negativen Reliefkopien, bei dem ein lichtempfindliches Material bildmäßig belichtet, danach erwärmt, nach dem Abkühlen nochmals ohne Vorlage belichtet und dann mittels eines wäßrigalkalischen Entwicklers entwickelt wird, dadurch gekennzeichnet, daß die lichtempfindliche Schicht das Gemisch gemäß Anspruch 1 enthält.

8. Verfahren nach Anspruch 7, dadurch gekennzeichnet, daß das Material nach der bildmäßigen Belichtung auf eine Temperatur im Bereich von 80 bis 120°C erwärmt wird.

9. Verfahren nach Anspruch 8, dadurch gekennzeichnet, daß das Material 0,5 bis 5 Minuten erwärmt wird.

**Revendications**

1. Composition photosensible renfermant, comme composé photosensible, un 1,2-quinonediazide, caractérisée en ce qu'elle contient en outre un composé d'ammonium quaternaire.

2. Composition photosensible selon la revendication 1, caractérisée en ce qu'elle contient 0,03 à 0,5 partie en poids du composé d'ammonium quaternaire pour chaque partie en poids de 1,2-quinonediazide.

3. Composition photosensible selon la revendication 1, caractérisée en ce que le composé

d'ammonium quaternaire est un composé de tétraalkylammonium, de trialkylarylammonium ou de N-alkylpyridinium.

4. Composition photosensible selon la revendication 1, caractérisée en ce que le composé d'ammonium quaternaire est un hydroxyde, un halogénure ou un p-toluènesulfonate.

5. Composition photosensible selon la revendication 1, caractérisée en ce qu'elle contient en plus un liant polymère insoluble dans l'eau et soluble dans les solutions hydroalcalines.

6. Composition photosensible selon la revendication 5, caractérisée en ce que le liant polymère est une résine Novolaque.

7. Procédé de fabrication de copies en relief négatives, dans lequel on expose, selon l'image, un matériau photosensible, puis on le chauffe, on l'expose encore une fois, après refroidissement, sans l'original, et on le développe ensuite au moyen d'un développateur hydroalcalin, caractérisé en ce que la couche photosensible contient la composition de la revendication 1.

8. Procédé selon la revendication 7, caractérisé en ce que le matériau est chauffé à une température comprise entre 80 et 120°C, après exposition selon l'image.

9. procédé selon la revendication 8, caractérisé en ce que le matériau est chauffé pendant 0,5 à 5 minutes.

**Claims**

1. Photosensitive composition which comprises a 1,2-quinone diazide as the photosensitive compound, characterized in that it additionally contains a quaternary ammonium compound.

2. A photosensitive composition as claimed in claim 1, characterized in that it contains from 0.03 to 0.5 part by weight of the quaternary ammonium compound, per part by weight of 1,2-quinone diazide.

3. A photosensitive composition as claimed in claim 1, wherein the quaternary ammonium compound comprises a tetraalkyl ammonium compound, a trialkylaryl ammonium compound, or a N-alkylpyridinum compound.

4. A photosensitive composition as claimed in claim 1, wherein the quaternary ammonium compound comprises a hydroxide, a halide, or a p-toluene sulfonate.

5. A photosensitive composition as claimed in claim 1, characterized in that it additionally contains a polymeric binder which is insoluble in water and soluble in aqueous-alkaline solutions.

6. A photosensitive composition as claimed in claim 5, wherein the polymeric binder comprises a novolak.

7. Process for the production of negative relief copies, comprising imagewise exposing a photosensitive material, thereafter heating the material and, after cooling, exposing the material again without original and then developing it by means of an aqueous-alkaline developer, wherein the photosensitve layer contains the mixture as claimed in claim 1.

8. A process as claimed in claim 7, wherein the material is heated to a temperature in the range from 80 to 120°C, after the imagewise exposure.

9. A process as claimed in claim 8, wherein the material is heated for 0.5 to 5 minutes.